Europäisches Patentamt

European Patent Office

Office européen des brevets

(19)

(11) Publication number: **0 219 895**

**A1**

(12) # EUROPEAN PATENT APPLICATION

(21) Application number: 86201607.8

(22) Date of filing: 17.09.86

(51) Int. Cl.⁴: **C04B 35/46** , C04B 35/50 , H01L 41/18 , H01L 41/22 , C04B 35/64

(30) Priority: 20.09.85 US 778582

(43) Date of publication of application:
29.04.87 Bulletin 87/18

(84) Designated Contracting States:
DE FR GB NL

(71) Applicant: **North American Philips Corporation**
**100 East 42nd Street 9th Floor**
**New York, N.Y. 10017(US)**

(72) Inventor: **Cross, Leslie Eric**
**INT. OCTROOIBUREAU B.V. Prof. Holstlaan 6**
**NL-5656 AA Eindhoven(NL)**
Inventor: **Schulze, Walter Arthur**
**INT. OCTROOIBUREAU B.V. Prof. Holstlaan 6**
**NL-5656 AA Eindhoven(NL)**
Inventor: **Rong, Xue Wan**
**INT. OCTROOIBUREAU B.V. Prof. Holstlaan 6**
**NL-5656 AA Eindhoven(NL)**

(74) Representative: **Auwerda, Cornelis Petrus et al**
**INTERNATIONAAL OCTROOIBUREAU B.V.**
**Prof. Holstlaan 6**
**NL-5656 AA Eindhoven(NL)**

(54) **Method of manufacturing piezoelectric ceramic elements.**

(57) A method of manufacturing a lead titanate piezoelectric ceramic element by sintering powdered material of the formula $(Pb_{1-1.5x}Ln_x)(Ti_{1-y}Mn_y)O_3$, Ln being selected from Sm and a 1:1 mixture of Gd and Nd, $0.06 \leq x \leq 0.14$ and $0.02 \leq y \leq 0.03$. A value of $k_t/k_p$ of 50 or more is obtained by quenching 8 to 20 vol% of the powdered material immediately after sintering, mixing this powder with unquenched powder in a quantity of 80-92 vol %, dispersing the powders together with a binder shaping it, sintering it and poling the shaped body in a field of 40-60 kV/cm.

EP 0 219 895 A1

## Method of manufacturing piezoelectric ceramic elements.

This invention relates to a method of manufacturing a lead titane piezoelectric ceramic element and to piezoelectric ceramic elements produced by this method.

Because of their relatively small dielectric constant, high Curie temperature and large anisotropy, the electromechanical coupling factor for the thickness dialational vibration $k_t$ being much larger than that for the planar extensional vibration $k_p$, sintered titanates ceramics are very useful piezoelectric materials for high temperature and high frequency use.

In H. Takeuchi et al, J. Acoust. Soc. Am. 72 - (4), October 1982, pages 114-120, it is shown that lead titanate ceramic materials which are substituted with manganese and with a rare earth such as samarium, gadolinium or neodymium, after poling, exhibit a high coupling factor ratio $k_t / k_p$. As shown in Fig. 4 this ratio may be as high as 15. Lead titanate ferroelectric materials which exhibit a $k_t/k_p$ ratio as high as 15 are satisfactory for many purposes.

However, it is desirable particularly for use in high frequency array transducer applications that the ratio $k_t/k_p$ at room temperature be further increased as possible while the value of the coupling factor for the thickness dialational vibration $k_t$ remain as high as possible.

An object of this invention is to produce a lead titanate piezoelectric material which after poling, exhibits a significantly higher $k_t/k_p$ ratio without any significant decrease in the value of $k_t$.

According to the invention it has been found the ratio $k_t/k_p$ may be significantly increased without decreasing the value of $k_t$ of a lead titanate piezoelectric ceramic material produced from a lead titanate material substituted with manganese and with a rare earth metal selected from samarium, gadolinium and neodymium a possibility of 8 to 20% by volume of the powder has been quenched immediately after sintering. The applicants have found that elements having a $k_t/k_p$ ratio of as high as 50 or more can be obtained.

The method according to the invention is characterized in a powdered mixture consisting of about 80-92% by volume of a sintered lead titanate powder of the formula $(Pb_{1-1.5x}Ln_x)$ $(Ti_{1-y}Mn_y)O_3$ where Ln is selected from the group consisting of Sm and a mixture of Gd and Nd in an atomic ratio of about 1 : 1, $0.06 \leq x \leq 0.14$, $0.02 \leq y \leq 0.03$ and 8 to 20% by volume of said powder which has been quenched immediately after sintering, is shaped in a mould with a temporary binder, sintered and finally poled in a field of 40 -60 kV/cm.

Preferably, quenching is accomplished by deionized water.

In order to produce the piezoelectric element the mixture is molded into plates with the use of a binder such as polyalcohol solution, removing the binder by heating the plates at about 500°C ato 600°C and then sintering the plates at 1.000°C to 1.400°C for about 1 to 5 hours in a lead oxide atmosphere. After suitable electrodes are attached to both major surfaces, poling is carried out in a silicon oil at a temperature of 120°C to 150°C with a field of 40-60 kV/cm for 3 to 10 minutes. An example of the preparation of a piezoelectric ceramic element of the invention is shown in the following example:

In order to manufacture elements of the formula $(Pb_{0.85}Sm_{0.10})(Ti_{0.98}Mn_{0.02}(O_3)$.

A mixture was made of the following oxides:

PbO -66.126 gm

$Sm_2O_3$ -6.076 gm

$TiO_2$ -27.325 gm

NO -0.607 gm

extra PbO -1.53 gm

(to replace Pb lost during calcining and sintering)

The mixed oxides were milled for 6 hours using zirconia balls in a plastic lined vessel and dried at 110°C and calcined in a closed $Al_2O_3$ vessel at 900°C for 1 hour. After calcining the resultant cake was again milled with zirconia for 24 hours and again dried.

The resultant dried powder was then sieved to pass an 80 mesh screen, mixed with 3-5 wt % of deionized water and pressed at 5.000 psi to form green disks. These green disks were then fired at 1200°C for 1 hour in a closed crucible containing a lead source $(PbZrO_3)$. A portion of these fired disks were then quenched directly from the furnace temperature into deionized water. After the quenched disks were ground and sized to pass an 80 mesh screen.

The remaining fired disks were also ground and sized to pass an 80 mesh screen.

A mixture of the water quenched and unquenched powder in the weight ratio of 1-10 was then mixed with 8% by weight of a 15% by weight of a polyvinylalcohol-solution and the disks were pressed from the mixture at 5.000 PSI in steel dies.

The binder was then removed by heating the disks at 550°C for about 1 to 2 hours. The disks were then fired in a closed aluminium $Al_2O_3$ crucible with a rising temperature of 200°C/hour, held at 1230°C for 3 hours and then allowed to freely cool to room temperature.

The disks were then polished and gold electrodes sputtered onto both major surfaces for poling. The electric poling was then carried out in silicon oil with a field of 50-60 kv/cm applied for 5 minutes at 150°C.

The results of electrical and electromechanical measurements made upon representative disk samples fabricated according to the method of the example is shown in the following Table I:

## TABLE I

| sample | D(mm) | t(mm) | C(pf) | tanδ | $d_{33}(\times 10^{-12}C/N)$ | Fm(Hz) | Fn(Hz) | F1(Hz) | F3(Hz) | F5(Hz) |
|---|---|---|---|---|---|---|---|---|---|---|
| 0-1 | 15.1 | 0.70 | 414 | 0.0125 | 60 | 180475 | 180646 | 3080000 | 10080000 | 16920000 |
| 0-2 | 15.3 | 0.78 | 395 | 0.0113 | 60 | 175246 | 175355 | 2820000 | 9160000 | 15360000 |
| 0-3 | 15.7 | 0.92 | 349 | 0.0113 | 58 | 171414 | 171534 | 2360000 | 7580000 | 12680000 |
| 0-4 | 15.7 | 1.25 | 256 | 0.0109 | 58 | 171289 | 171383 | 1740000 | 5660000 | 9480000 |
| 1-1 | 28.0 | 1.60 | 631 | 0.0112 | 57 | 94488 | 94541 | 1340000 | 4340000 | 7260000 |
| 1-2 | 28.0 | 1.60 | 646 | 0.0114 | 57 | 94183 | 94264 | 1340000 | 4360000 | 7320000 |
| 1-3 | 28.0 | 1.60 | 630 | 0.0117 | 58 | 94207 | 94307 | 1300000 | 4260000 | 7140000 |
| 1-4 | 28.0 | 1.60 | 622 | 0.0114 | 57 | 93709 | 93790 | 1300000 | 4270000 | 7140000 |

| Kp(%)* | Kt(%)* | Kt/Kp |
|---|---|---|
| 0.85 | 47 | 55 |
| 0.86 | 44 | 51 |
| 0.62 | 41 | 66 |
| 0.68 | 44 | 65 |
| 0.65 | 43 | 66 |
| 0.84 | 44 | 52 |
| 0.92 | 46 | 50 |
| 0.58 | 46 | 78 |

* ----- The results were measured at room temperature (25°C).

+ ----- Kp values were measured by circle diagram (i.e, the vector impedance method).

In this table:

D = diameter
t = thickness
C = capacitance
$d_{33}$ = piezoelectric strain constant
Fm -- frequency at minimum impedance
Fn -- frequency at maximum impedance
$F_1$ -- fundamental resonance frequency of the thickness mode
$F_3$ -- first overtone resonance frequency of the thickness mode
$F_5$ -- second overtone resonance frequency of the thickness mode

As shown by Table I all the samples exhibited a $k_t/k_p$ ratio of greater value than 50 with a high value of $k_t$ and a very low value $k_p$ at room temperature.

The effect of variations in the concentration of the water quenched powder and of variations in poling voltages in a representative powder of the invention is shown in the following Table II:

# TABLE II

## $PbTiO_3$ + 10 mole% Sm + 2 mole% Mn

### POLING VOLTAGE $(KV/CM)^*$

| Volume % Water Quenched Powder | | 20 | 30 | 40 | 50 | 60 | 65 | 68 | 70 | 75 |
|---|---|---|---|---|---|---|---|---|---|---|
| **sample 5** | | | | | | | | | | |
| 16.7% | $k_t(\%)$ | 29 | 37 | 39 | 41 | 42 | 42 | 42 | -- | -- |
| | $k_p(\%)$ | 1.58 | 1.43 | 1.05 | 0.72 | 0.00 | 0.00 | 0.00 | -- | -- |
| | $K_t/k_p$ | 18.35 | 25.87 | 37.14 | 61.11 | 0.00 | 0.00 | 0.00 | -- | -- |
| **sample 6** | | | | | | | | | | |
| 11.1% | $k_t(\%)$ | 21 | 31 | 35 | 37 | 37 | 37 | -- | 37 | 37 |
| | $k_p(\%)$ | 1.96 | 1.71 | 1.30 | 0.96 | 0.68 | 0.55 | -- | 0.39 | 0.39 |
| | $k_t/K_p$ | 10.7 | 18.13 | 26.92 | 38.54 | 54.41 | 67.27 | -- | 94.87 | 94.87 |
| **sample 7** | | | | | | | | | | |
| 10% | $k_t(\%)$ | 28 | 36 | 42 | 44 | 46 | 45 | -- | 44 | -- |
| | $k_p(\%)$ | 1.81 | 1.55 | 1.09 | 0.86 | 0.00 | 0.00 | -- | OO | -- |
| | $k_t/k_p$ | 15.47 | 23.23 | 38.53 | 51.16 | 0.00 | 0.00 | -- | OO | -- |
| **sample 8** | | | | | | | | | | |
| 8.3% | $k_t(\%)$ | -- | -- | 28 | 33 | 35 | -- | -- | -- | -- |
| | $k_p(\%)$ | 1.91 | 1.74 | 1.17 | 0.87 | 0.78 | -- | -- | -- | -- |
| | $K_t/k_p$ | -- | -- | 23.93 | 37.93 | 44.87 | -- | -- | -- | -- |

\* Poling carried out at $150^oC$ for 5 minutes.

The effect of variations in the concentration of manganese in the planar coupling and radial coupling is shown in the following Table III:

## Table III

PbTiO$_3$ + 10 Mole% Sm (10 Volume % Water Quenched Powder).

POLING VOLTAGE (kV/cm)[*]

| | 50 | 60 |
|---|---|---|
| **0.02 Mole Mn** | | |
| kt(%) | 48 | 47 |
| kp(%) | 0.63 | 0 |
| $k_t/k_p$ | 76.2 | $\infty$ |
| **0.025 Mole Mn** | | |
| $k_t$(%) | 40 | 41 |
| $k_p$(%) | 0 | 0 |
| $k_t/k_p$ | $\infty$ | $\infty$ |
| **0.03 Mole Mn** | | |
| $k_t$(%) | 48 | - |
| $k_p$(%) | 1.7 | 1.5 |
| $k_t/k_p$ | 28.2 | - |

[*] Poled at 150°C for 5 minutes.

While the present invention has been described with references to particular embodiments thereof, it will be understood that numerous modifications may be made by those skilled in the art without actually departing from the scope of the invention.

## Claims

1. A method of manufacturing a lead titanate piezoelectric ceramic element comprising lead titanate material, substituted with manganese and with a rare earth metal, selected from samarium, gadolinium and neodynium, characterized in that a powdered mixture, consisting of about 80-92 volume % of a sintered lead titanate powder of the formula (Pb$_{1-1.5x}$Ln$_x$) (Ti$_{1-y}$Mn$_y$) O$_3$ wherein Ln is selected from the group consisting of Sm and a mixture of Gd and Nd in an atomic ratio of about 1:1, $0.06 \leq x \leq 0.14$, $0.02 \leq y \leq 0.03$ and 8-20% by volume of said powder, which has been quenched immediately after sintering, is shaped in a mould with a temporary binder, sintered and finally poled in a field of 40 - 60 kV/cm.

2. A method as claimed in Claim 1, characterized in that Ln is Sm.

3. A method as claimed in Claim 2, characterized in that $0.07 \leq x \leq 0.12$.

4. A method as claimed in Claim 3, characterized in that x is about 0.1.

5. A method as claimed in any one of Claims 1 to 4, characterized in that the powder is water quenched.

6. A piezoelectric ceramic element manufactured by any one of Claims 1 to 5.

| | DOCUMENTS CONSIDERED TO BE RELEVANT | | EP 86201607.8 |
|---|---|---|---|
| **Category** | Citation of document with indication, where appropriate, of relevant passages | Relevant to claim | **CLASSIFICATION OF THE APPLICATION (Int. Cl.4)** |
| A | DE - A1 - 3 135 041 (MURATA MANU-FACTURING CO., LTD.) <br> * Claims 1,2 * <br> ---- | 1 | C 04 B 35/46 <br> C 04 B 35/50 <br> H 01 L 41/18 <br> H 01 L 41/22 <br> C 04 B 35/64 |
| | | | **TECHNICAL FIELDS SEARCHED (Int. Cl.4)** |
| | | | C 04 B <br> H 01 L <br> H 01 B |
| | The present search report has been drawn up for all claims | | |

| Place of search | Date of completion of the search | Examiner |
|---|---|---|
| VIENNA | 05-12-1986 | BECK |